(19) Europäisches Patentamt
European Patent Office
Office européen des brevets

(11) **EP 1 537 671 B1**

(12) **EUROPEAN PATENT SPECIFICATION**

(45) Date of publication and mention
of the grant of the patent:
**13.02.2008 Bulletin 2008/07**

(51) Int Cl.:
***H03M 1/66*** (2006.01)  ***G11C 16/34*** (2006.01)

(21) Application number: **03749600.7**

(22) Date of filing: **09.09.2003**

(86) International application number:
**PCT/US2003/028479**

(87) International publication number:
**WO 2004/025389 (25.03.2004 Gazette 2004/13)**

(54) **DAC-BASED VOLTAGE REGULATOR FOR FLASH MEMORY ARRAY**

AUF EINEM DAC BASIERENDER SPANNUNGSREGLER FÜR EIN FLASH-SPEICHERARRAY

REGULATEUR DE TENSION BASE SUR UN CONVERTISSEUR NUMERIQUE/ANALOGIQUE POUR UN ENSEMBLE DE MEMOIRES FLASH

(84) Designated Contracting States:
**DE FR GB NL**

(30) Priority: **11.09.2002 IT TO20020790**
**03.04.2003 US 407647**

(43) Date of publication of application:
**08.06.2005 Bulletin 2005/23**

(73) Proprietor: **ATMEL CORPORATION**
**San Jose, California 95131 (US)**

(72) Inventors:
• **FRULIO, Massimiliano**
**I-20135 Milano (IT)**
• **SIVERO, Stefano**
**I 21029 Vergiate (IT)**
• **BARTOLI, Simone**
**IT-20090 Carbiago (IT)**
• **MOGNONI, Sabina**
**IT-20052 Monza (IT)**

(74) Representative: **Leeming, John Gerard**
**J.A. Kemp & Co.**
**14 South Square**
**Gray's Inn**
**London WC1R 5JJ (GB)**

(56) References cited:
**EP-A- 0 701 259       US-A- 5 221 890**
**US-A- 5 453 953       US-A- 5 563 499**
**US-A- 5 815 012       US-A- 6 011 724**
**US-A1- 2002 145 892   US-B1- 6 441 593**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

**Description**

The present invention relates to charge pump circuits. More particularly, the present invention relates to a digital-to-analog-converter (DAC) based voltage regulator system that can regulate the output of charge pump circuits in a non-volatile memory for supplying various voltages utilized in the memory circuit.

Non-volatile memories require a broad range of voltages that are applied to the word lines coupled to the gates of the memory cell transistors. A plurality of voltage regulators provide the different appropriate voltages for each operation of the device. The output voltage of each voltage regulator is fixed and there is no way to change the output voltages of the regulator devices. An example of a voltage regulator is disclosed in US 5,221,890A.

A non-volatile memory requires at least a voltage regulator for supplying a voltage to the memory cell gates for verifying a programmed cell and an erased cell, and a voltage regulator for supplying a programming voltage to the memory cell gates for programming memory cells. In some non-volatile memory devices the reliability of the cell requires that the program voltage not be constant but rather that the voltage is ramped. Additional analog circuits need to be provided for this purpose. Examples of circuits for ranging voltages are disclosed in EP 0,701,259A and US 6,011,724A.

The present invention provides a DAC-based integrated voltage regulator, as defined in the appended claims, e.g. for supplying the necessary regulated voltages to a non-volatile memory device. The voltage regulation is based on a current comparison between a reference current and a current signal obtained from the high-voltage output of the charge pump circuit. The N bits provided to the DAC generate 2N current-reference levels that are sunk from a virtual ground. A voltage to current converter generates a current signal from the high-voltage output of the charge pump that is supplied to virtual ground. The current-error signal that comes from the comparison in the virtual ground is amplified and voltage converted by a transconductance amplifier. A second amplifier receives the output signal from the transconductance amplifier and outputs a CMOS-compatible voltage level that enables or discharges the charge pump in order to obtain the selected output voltage value. Thus, the charge pump can be regulated to one of $2^N$ values according to the input presented to the DAC.

The voltage regulator of the present invention is capable of supplying a wide range of output voltages to bias the word lines in a non-volatile memory device. N input signals are provided in order to select the appropriate output voltage for each operation of the non-volatile memory. Because of this feature, a voltage ramp can easily be generated by providing the sequence of the values of the ramp.

BRIEF DESCRIPTION OF THE DRAWING FIGURES

FIG. 1 is a block diagram of a charge-pump system 10 including the DAC-based voltage regulator of the present invention.
FIG. 2 is a schematic diagram of an illustrative DAC-based voltage regulator according to the present invention.
FIG. 3 is a detailed schematic diagram of an illustrative embodiment of circuit usable as the current source of FIG. 2.

DETAILED DESCRIPTION OF THE INVENTION

Persons of ordinary skill in the art will realize that the following description of the present invention is only illustrative and not in any way limiting. Other embodiments of this invention will be readily apparent to those skilled in the art having benefit of this disclosure.

The voltage regulation is based on a current comparison between a reference current and a current signal obtained from the high-voltage output of the charge pump circuit. The N bits provided to the DAC generate $2^N$ current-reference levels that are sunk from a virtual ground. A voltage to current converter generates a current signal from the high-voltage output of the charge pump that is supplied to virtual ground. The current-error signal that comes from the comparison in the virtual ground is amplified and voltage converted by a transconductance amplifier. A second amplifier receives the output signal from the transconductance amplifier and outputs a CMOS-compatible voltage level that enables or discharges the charge pump in order to obtain the selected output voltage value. Thus, the charge pump can be regulated to one of $2^N$ values according to the input presented to the DAC.

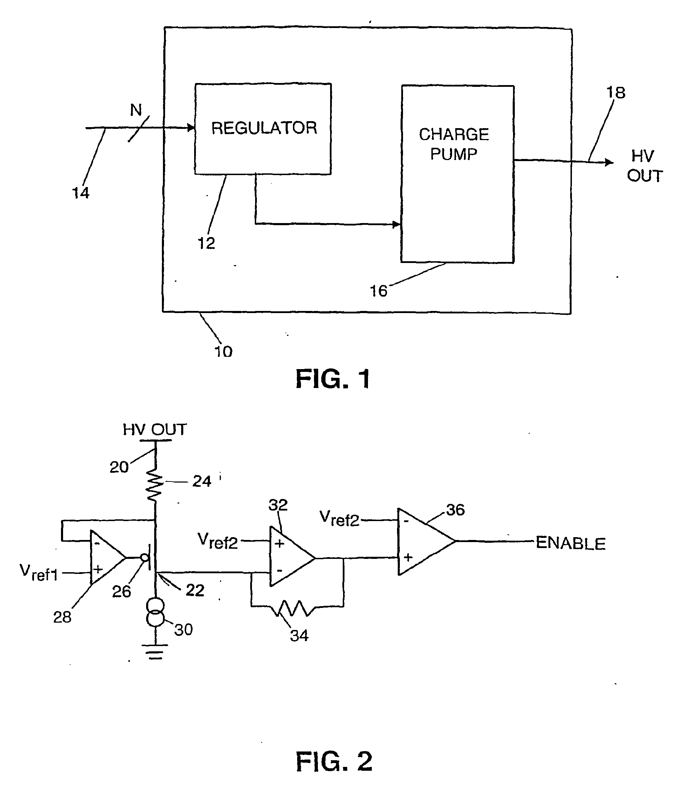

Referring first to FIG. 1, a block diagram of a charge-pump system 10 including the DAC-based voltage regulator of the present invention is presented. DAC-based voltage regulator 12 accepts an N-bit digital input on bus 14. DAC-based voltage regulator 12 supplies an enable signal to the charge pump 16 that either enables or discharges the charge pump 16 to regulate its high-voltage output at output node 18.

Referring now to FIG. 2, a simplified schematic diagram of the DAC-based regulator of the present invention is shown. The high-voltage output node of the charge pump (shown at reference numeral 20) is coupled to a virtual ground node 22 through resistor 24 and p-channel MOS transistor 26. P-channel MOS transistor 26 is driven from the output of amplifier 28. Amplifier 28 has its inverting input coupled to the connection between resistor 24 and the source of p-channel MOS transistor 26 and its non-inverting input coupled to a reference voltage $V_{ref1}$. Current source 30 can source $2^N$ levels of reference currents depending on the state of its N-input lines and is coupled to a circuit node comprising the drain of p-channel MOS transistor 26 and the inverting input of transconductance amplifer 32. Persons of ordinary skill in the art will appreciate that this circuit node is at virtual ground. The non-inverting input of transconductance amplifier 32 is coupled to a reference voltage $V_{ref2}$. Resistor 34 sets the gain of transconductance amplifier 32. Transconductance amplifier 32 drives the non-inverting input of transconductance amplifier 36. The inverting input of transconductance amplifier 36 is coupled to the reference voltage $V_{ref2}$.

Resistor 24, amplifier 28 and p-channel MOS transistor 26 generate a current signal that is a function of the voltage at the high-voltage output node 20 of the charge pump. This current signal is compared with the reference current signal from the current source 30. As will be disclosed more fully herein, the reference current may be set to one of $2^N$ levels.

The current error signal resulting from the comparison in the virtual ground is amplified and converted to a voltage in transconductance amplifier 32. The second amplifier 36 generates CMOS-compatible output levels to enable or discharge the charge pump.

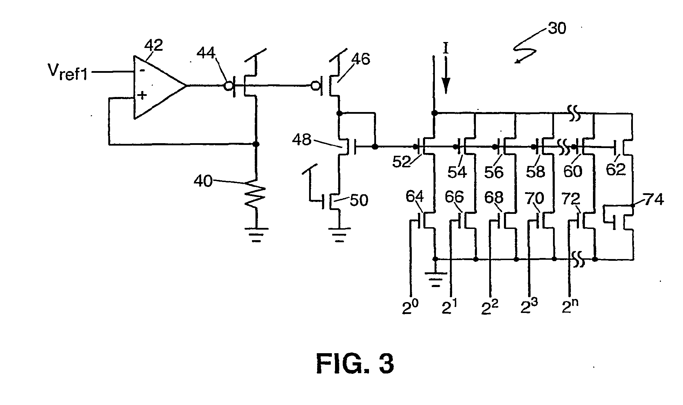

Referring now to FIG. 3, current source 30 from FIG. 2 is shown in detail. The reference current is obtained from the resistor 40 biased from a constant-voltage drop $V_{ref1}$ controlled from amplifier 42 and p-channel MOS transistor 44. P-channel MOS transistor 46 and N-channel MOS transistors 48 and 50 mirror the current through p-channel MOS transistor 44. N-channel MOS transistors 52, 54, 56, 58, 60, and 62 are sized to multiply the current by powers of 2; transistor 52 is sized 1x; transistor 54 is sized 2x; transistor 56 is sized 4x; transistor 58 is sized 8x; transistor 60 is sized $(2^N)$x. Transistor 62 is minimum sized to bias the current source to a minimum current value. The current paths through transistors 52,54, 56,58, 60, and 62 are switched, respectively, by transistors 64,66, 68,70, 72, and 74. Transistors 64,66, 68,70, and 72 have their gates driven by a respective one of the N input control lines. Transistor 74 is diode connected to source minimum current when all of the N input lines are at logic zero.

The generation of the current signal from the high-voltage output node 20 (FIG. 2) of charge pump 30 is made by the amplifier 28 biasing its feedback loop at $V_{ref1}$. The value of the high-voltage output may be expressed as:

$$HVOUT=(n+1)\,(R24/R40)\cdot V_{ref1}+V_{ref1}$$

As will be appreciated by persons of ordinary skill in the art, the regulation is a function of the ratio of the resistors and not the absolute value.

**Claims**

1. A DAC-based integrated voltage regulator system (10) comprising:

   a charge pump circuit (16) having an enable input and a voltage output node;
   a virtual ground node (22);
   N digital inputs (14);
   a voltage-to-current converter having an input coupled to said voltage output node and an output coupled to said virtual ground node;
   a current source (30) coupled to said virtual ground node, said current source sinking one of a plurality of currents in response to states signal on said N digital inputs;
   a transconductance amplifier (32) having an inverting input at said virtual ground node, a non-inverting input coupled to a reference voltage potential, and an output;
   and a comparator (36) having a first input coupled to said output of said transconductance amplifier, a second input coupled to a reference voltage potential, and an output coupled to said enable input of said charge pump.

2. The integrated voltage regulator system of claim 1 in combination with a non-volatile memory circuit.

3. The DAC-based voltage regulator system of claim 1 wherein said current source comprises:

   a reference-voltage source;
   an amplifier (42) having an inverting input coupled to said reference-voltage source, a non-inverting input, and an output;
   a first p-channel MOS transistor (44) having a source coupled to a supply potential, a drain coupled to said non-inverting input of said amplifier, and a gate coupled to said output of said amplifier;
   a second p-channel MOS transistor (46) having a source coupled to said supply potential, a drain, and a gate coupled to said output of said amplifier;
   a first n-channel MOS transistor (48) having a drain and a gate coupled to the drain of said second p-channel MOS transistor, and a source;
   a second n-channel MOS transistor (50) having a drain coupled to said source of said first n-channel MOS transistor, a gate coupled to said supply potential, and a source coupled to ground;
   a current-sink node;
   a bias circuit coupled between said current-sink node and ground potential, said bias circuit including a minimum-sized n-channel MOS bias transistor having a drain coupled to said current sink node, a gate coupled to the gate of said first n-channel MOS transistor and a source coupled to ground potential through a diode-connected n-channel MOS transistor; and

N digital input stages, each digital input stage coupled between said current- sink node and ground potential and including a first input-stage n-channel MOS transistor (52-62) having a drain coupled to said current sink node, a gate coupled to the gate of said first n-channel MOS transistor and a source coupled to ground potential through a second input- stage n-channel MOS transistor, said second input-stage n-channel MOS transistor (64-74) having a gate coupled to one of said N digital inputs.

**Patentansprüche**

1.  DAC-basiertes, integriertes Spannungs-Regulator-System (10) umfassend:

    • einen Ladungspumpen-Schaltkreis (16) mit einem Freigabe-Eingang und einem Spannungs-Ausgangs-Knoten;
    • einen virtuellen Masse-Knoten (22);
    • N digitale Eingänge (14);
    • einen Spannung-Strom-Konverter mit einem Eingang, welcher mit dem Spannungs-Ausgangs-Knoten gekoppelt ist, und einem Ausgang, welcher mit dem virtuellen Masse-Knoten gekoppelt ist;
    • eine Stromquelle (30), welche mit dem virtuellen Masse-Knoten gekoppelt ist, wobei die Stromquelle, als Antwort auf ein Zustandssignal auf den N digitalen Eingängen, einen aus einer Mehrzahl von Strömen abführt;
    • einen Transkonduktanz-Verstärker (32) mit einem invertierenden Eingang an dem virtuellen Masse-Knoten, mit einem nicht-invertierenden Eingang, welcher mit einem Referenzspannungs-Potential gekoppelt ist, und mit einem Ausgang;
    • und einen Komparator (36) mit einem ersten Eingang, welcher mit dem Ausgang des Transkonduktanz-Verstärkers gekoppelt ist, einem zweiten Eingang, welcher mit einem Referenzspannungs-Potential gekoppelt ist, und einem Ausgang, welcher mit dem Freigabe-Eingang der Ladungspumpe gekoppelt ist.

2.  Integriertes Spannungs-Regulator-System nach Anspruch 1 in Kombination mit einem nicht-volatilen Speicher-Schaltkreis.

3.  DAC-basiertes Spannungs-Regulator-System nach Anspruch 1, wobei die Spannungsquelle umfasst:

    • eine Referenz-Spannungsquelle;
    • einen Verstärker (42) mit einem invertierenden Eingang, welcher mit der Referenz-Spannungsquelle gekoppelt ist, mit einem nicht-invertierenden Eingang und mit einem Ausgang;
    • einen ersten p-Kanal-MOS-Transistor (44) mit einem Source-Anschluss, welcher mit einem Versorgungs-Potential gekoppelt ist, mit einem Drain-Anschluss, welcher mit dem nicht-invertierenden Eingang des Verstärkers gekoppelt ist, und einem Gate-Anschluss, welcher mit dem Ausgang des Verstärkers gekoppelt ist;
    • einen zweiten p-Kanal-MOS-Transistor (46) mit einem Source-Anschluss, welcher mit dem Versorgungs-Potential gekoppelt ist, mit einem Drain-Anschluss und mit einem Gate-Anschluss, welcher mit dem Ausgang des Verstärkers gekoppelt ist;
    • einen ersten n-Kanal-MOS-Transistor (48) mit einem Drain- und einem Gate-Anschluss, welche mit dem Drain-Anschluss des zweiten p-Kanal-MOS-Transistors gekoppelt sind, und mit einem Source-Anschluss;
    • einen zweiten n-Kanal-MOS-Transistor (50) mit einem Drain-Anschluss, welcher mit dem Source-Anschluss des ersten n-Kanal-MOS-Transistors gekoppelt ist, mit einem Gate-Anschluss, welcher mit dem Versorgungs-Potential gekoppelt ist, und mit einem Source-Anschluss, welcher mit Masse gekoppelt ist;
    • einen Strom-Senke-Knoten;
    • einen Vorspannungs-Schaltkreis, welcher zwischen dem Strom-Senke-Knoten und dem Masse-Potential gekoppelt ist, wobei der Vorspannungs-Schaltkreis einen n-Kanal-MOS-Vorspannungs-Transistor minimaler Größe beinhaltet, mit einem Drain-Anschluss, welcher mit dem Strom-Senke-Knoten gekoppelt ist, mit einem Gate-Anschluss, welcher mit dem Gate-Anschluss des ersten n-Kanal-MOS-Transistors gekoppelt ist und mit einem Source-Anschluss, welcher über einen Dioden-verbundenen n-Kanal-MOS-Transistor mit dem Masse-Potential gekoppelt ist; und
    • N digitale Eingangsstufen, wobei jede digitale Eingangsstufe zwischen dem Strom-Senke-Knoten und dem Masse-Potential gekoppelt ist und einen ersten Eingangsstufen-n-Kanal-MOS-Transistor (52-62) beinhaltet mit einem Drain-Anschluss, welcher mit dem Strom-Senke-Knoten gekoppelt ist, mit einem Gate-Anschluss, welcher mit dem Gate-Anschluss des ersten n-Kanal-MOS-Transistors gekoppelt ist, und mit einem Source-Anschluss, welcher über einen zweiten Eingangs-Stufen-n-Kanal-MOS-Transistor mit dem Masse-Potential gekoppelt ist, wobei der zweite Eingangsstufen-n-Kanal-MOS-Transistor (64-74) einen Gate-Anschluss besitzt, welcher mit einem der N digitalen Eingänge gekoppelt ist.

## Revendications

1. Système régulateur de tension intégré basé sur un CNA (10) comprenant :

   un circuit de pompe à charge (16) ayant une entrée de validation et un noeud de sortie de tension ;
   un noeud de masse virtuelle (22) ;
   N entrées numériques (14) ;
   un convertisseur tension-courant ayant une entrée couplée audit noeud de sortie de tension et une sortie couplée audit noeud de masse virtuelle ;
   une source de courant (30) couplée audit noeud de masse virtuelle, ladite source de courant recevant un courant parmi une pluralité de courants en réponse à un signal d'états desdites N entrées numériques ;
   un amplificateur de transconductance (32) ayant une entrée inverseuse audit noeud de masse virtuelle, une entrée non inverseuse couplée à un potentiel de tension de référence, et une sortie ;
   et un comparateur (36) ayant une première entrée couplée à ladite sortie dudit amplificateur de transconductance, une seconde entrée couplée au potentiel de tension de référence, et une sortie couplée à ladite entrée de validation de ladite pompe à charge.

2. Système régulateur de tension intégré selon la revendication 1, en combinaison avec un circuit de mémoire non volatile.

3. Système régulateur de tension basé sur un CNA selon la revendication 1, dans lequel ladite source de courant comporte :

   une source de tension de référence ;
   un amplificateur (42) ayant une entrée inverseuse couplée à ladite source de tension de référence, une entrée non-inverseuse, et une sortie ;
   un premier transistor MOS à canal p (44) ayant une source inverseuse couplée à un potentiel d'alimentation, un drain couplé à ladite entrée non-inverseuse dudit amplificateur, et une grille couplée à ladite sortie dudit amplificateur ;
   un second transistor MOS à canal p (46) ayant une source couplée audit potentiel d'alimentation, un drain, et une grille couplée à ladite sortie dudit amplificateur ;
   un premier transistor MOS à canal n (48) ayant un drain et une grille couplée au drain dudit second transistor MOS à canal p, et une source ;
un second transistor MOS à canal n (50) ayant un drain couplé à ladite source dudit premier transistor MOS à canal n, une grille couplée audit potentiel d'alimentation, et une source couplée à la masse ;
un noeud récepteur de courant ;
un circuit de polarisation monté entre ledit noeud récepteur de courant et le potentiel de masse, ledit circuit de polarisation incluant un transistor de polarisation MOS à canal n de dimension minimum ayant un drain couplé audit noeud récepteur de courant, une grille couplée à la grille dudit premier transistor MOS à canal n et une source couplée au potentiel de masse par l'intermédiaire d'un transistor MOS à canal n connecté à une diode ; et
N étages d'entrée numérique, chaque étage d'entrée numérique étant monté entre ledit noeud récepteur de courant et le potentiel de masse et incluant un premier transistor MOS à canal n d'étage d'entrée (52-62) ayant un drain couplé audit noeud récepteur de courant, une grille couplée à la grille dudit premier transistor MOS à canal n et une source couplée au potentiel de masse par l'intermédiaire d'un second transistor MOS à canal n d'étage d'entrée, ledit second transistor MOS à canal n d'étage d'entrée (64-74) ayant une grille couplée à une desdites N entrées numériques.

REGULATOR

CHARGE PUMP

18

HV OUT

N

14

12

16

10

**FIG. 1**

HV OUT

20

24

$V_{ref1}$

26

22

28

30

32

$V_{ref2}$

34

$V_{ref2}$

36

ENABLE

**FIG. 2**

FIG. 3

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5221890 A
- EP 0701259 A
- US 6011724 A